# EUROPEAN PATENT APPLICATION

(11) **EP 2 648 211 A1**
(43) Date of publication of application: **09.10.2013**
(21) Application number: 11845216.8
(22) Date of filing: 29.11.2011
(51) Int. Cl.: H01L 21/225, H01L 31/04

(54) **COATING LIQUID FOR IMPURITY DIFFUSION**

(30) Priority: 29.11.2010 JP 2010265349; 08.12.2010 JP 2010273579; 08.12.2010 JP 2010273662
(71) Applicant: The Nippon Synthetic Chemical Industry Co., Ltd., Osaka 530-0018 (JP)
(72) Inventor: SATO Hiroaki, Osaka-shi Osaka 530-0018 (JP); KATSUMA Katsuhiko, Osaka-shi Osaka 530-0018 (JP); KATO Kuniyasu, Osaka-shi Osaka 530-0018 (JP); TSUTSUMI Yuka, Osaka-shi Osaka 530-0018 (JP)
(74) Representative: Kuhnen & Wacker
(86) International application number: PCT/JP2011/077454
(87) International publication number: WO 2012/073920

(57) **Abstract**

Disclosed is a coating liquid for impurity diffusion comprising: (A) a polyvinyl alcohol resin having a 1,2-diol structural unit represented by the following general formula (1): 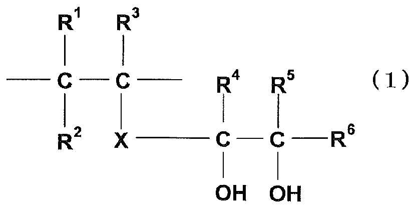 wherein R¹, R² and R³ each independently represent a hydrogen atom or an organic group, X represents a single bond or a bond chain, and R⁴, R⁵ and R⁶ each independently represent a hydrogen atom or an organic group; (B) an impurity; and (C) water. The coating liquid for impurity diffusion is highly stable, and exhibits excellent printing properties; for example, when printing is continuously carried out for a longer period of time or resumed after a pause. Accordingly, the coating liquid for impurity diffusion is particularly suitable as a coating liquid for impurity diffusion for use for applying by screen printing.

## Description

### TECHNICAL FIELD

The present invention relates to a coating liquid for impurity diffusion which is applied onto a semiconductor substrate to form an impurity diffusion layer on the substrate, and more specifically, to a coating liquid for impurity diffusion suitable for applying by screen printing.

### BACKGROUND ART

In process of producing a semiconductor set in semiconductor devices such as transistors and diodes, it is a widely used method for forming an impurity diffusion layer in the substrate by applying a liquid material containing an impurity such as phosphorus or boron on a semiconductor substrate of such as germanium or silicon to form a film and then burning the resulting substrate.

A spin coating method is generally used for applying the liquid material on the substrate. In recent years, however, the wafer size has been increased for reduction of production costs, and if the substrate has a diameter of 4 inches or greater, it is difficult to form a film having a uniform thickness by the spin coating method.

Therefore, it is contemplated to use a screen printing method which ensures liquid application on a greater size wafer, and a coating liquid for impurity diffusion which is suitable for the printing method is proposed (for example, refer to JP-A-2007-53353 and JP-A-2007-35719).

The coating liquid for impurity diffusion described in JP-A-2007-53353 or JP-A-2007-35719, comprising a phosphorus compound or a boron compound as an impurity, a water-soluble polymer such as a polyvinyl alcohol, and water, has a specific range of viscosity, and is capable of forming a uniform film on a semiconductor substrate by the screen printing method. The film is thereafter heat-treated to form an impurity diffusion layer, and a semiconductor having a reduced variation in resistance is achieved.

As for production of solar cells, it is often necessary to form a pattern of an impurity diffusion layer on a semiconductor substrate. A method including a coating liquid applying step followed by an etching step, or a method including a mask pattern forming step followed by a coating liquid applying step is conventionally employed for the pattern formation. In contrast, the screen printing method using the coating liquid for diffusion described in JP-A-2007-53353 and JP-A-2007-35719 is capable of performing pattern printing, thereby obviating the aforementioned steps. Therefore, the screen printing method is highly useful for the production of the solar cells.

### SUMMARY OF INVENTION

However, the coating liquid for diffusion used for screen printing typically contains an organic solvent miscible with water in order to control the drying speed and the fluidity of the film, which helps improve the leveling property of the film. In the coating liquids described in JP-A-2007-53353 and JP-A-2007-35719, the polyvinyl alcohol in the coating liquid has a lower solubility in the organic solvent. Therefore, the each coating liquid is liable to increase its viscosity with time or suffer from precipitation of insoluble substances depending on the composition thereof and the conditions when used. Where the screen printing is continuously carried out or resumed after an idle period, printing failure or incomplete pattern is liable to occur due to the clogging of a screen mesh.

Therefore, an object of the present invention is to provide a highly stable coating liquid for impurity diffusion which exhibits excellent printing properties when the printing is continuously carried out for a longer period of time or carried out after an idle period and hence is particularly suitable for the screen printing.

As a result of intensive studies conducted in the view of the foregoing, the object of the present invention was accomplished by achieving a coating liquid for impurity diffusion which comprises: (A) a polyvinyl alcohol resin having a 1,2-diol structural unit represented by the following general formula (1) (the polyvinyl alcohol is hereinafter referred to as "PVA") : 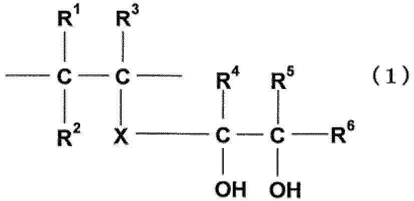 wherein R¹, R² and R³ each independently represent a hydrogen atom or an organic group, X represents a single bond or a bond chain, and R⁴, R⁵ and R⁶ each independently represent a hydrogen atom or an organic group; (B) an impurity; and (C) water.

That is, the present invention has a main feature such that, in the coating liquid for impurity diffusion comprising the PVA resin, the impurity (a phosphorus compound or a boron compound), and water, the PVA resin has the specific structural unit having the 1,2-diol structure on its side chain.

The inventive coating liquid for impurity diffusion is highly stable. Where the coating liquid for impurity diffusion is used for screen printing, therefore, the printing can be continuously carried out for a longer period of time or can be resumed after an idle period. Particularly in the pattern printing of the solar cells, the coating liquid for impurity diffusion ensures higher printing accuracy for a longer period of time. Thus, the coating liquid for impurity diffusion is industrially very useful.

### DESCRIPTION OF EMBODIMENTS

The following describes an exemplary (representative example) embodiment of the present invention; therefore, the present invention is not limited to the following embodiment.

The present invention will hereinafter be described in detail.

The inventive coating liquid for impurity diffusion comprises:
(A) a PVA resin having a structural unit represented by the general formula (1);
(B) an impurity such as a phosphorus compound and a boron compound; and
(C) water.

These components are described hereinafter one by one.

### <PVA resin (A) >

Firstly, the PVA resin (A) used in the present invention is described below.

The PVA resin used for the coating liquid for impurity diffusion has the structural unit represented by the following general formula (1): 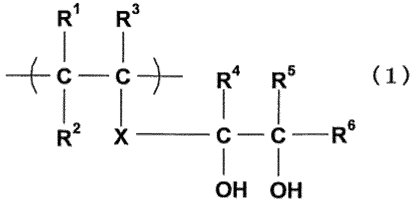 wherein R¹, R² and R³ each independently represent a hydrogen atom or an organic group, X represents a single bond or a bond chain, and R⁴, R⁵ and R⁶ each independently represent a hydrogen atom or an organic group.

Particularly, it is most preferred that, in the 1,2-diol structural unit represented by the general formula (1), R¹ to R³ and R⁴ to R⁶ are all hydrogen atoms, and X is a single bond. That is, a PVA resin having a structural unit represented by the following general formula (1') is preferably used:

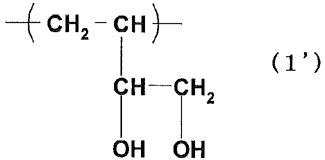

In the structural unit represented by the general formula (1), R¹ to R³ and R⁴ to R⁶ may each be an organic group, which may be present in an amount that does not significantly impair the properties of the resin. Examples of the organic group include C₁ to C₄ alkyl groups such as a methyl group, an ethyl group, an n-propyl group, an isopropyl group, an n-butyl group, an isobutyl group and a tert-butyl group. These organic groups may have a functional group such as a halogen group, a hydroxyl group, an ester group, a carboxyl group or a sulfonic acid group as required.

In the structural unit represented by the general formula (1), X is most preferably a single bond, which helps ensure thermal stability and stability under higher temperature or acidic conditions, but may be a bond chain as long as the effects of the present invention are not impaired. Examples of the bond chain include hydrocarbon chains such as alkylenes, alkenylenes, alkynylenes, phenylene and naphthylene (which may be substituted with a halogen such as fluorine, chlorine or bromine), and -O-, -(CH₂O)ₘ-, -(OCH₂)ₘ-, -(CH₂O)ₘCH₂-, -CO-, -COCO-, -CO(CH₂)ₘCO-, -CO(C₆H₄)CO-, -S-, -CS-, -SO-, -SO₂-, -NR-, -CONR-, -NRCO-, -CSNR-, -NRCS-, -NRNR-, -HPO₄-, -Si(OR)₂-, -OSi(OR)₂-, -OSi(OR)₂O-, -Ti(OR)₂-, -OTi(OR)₂-, -OTi(OR)₂O-, -Al(OR)-, -OAl(OR)- and -OAl(OR)O- (wherein each R is independently a given substituent, preferably a hydrogen atom or an alkyl group, and each m is a natural number). Particularly, X is preferably an alkylene group having not greater than six carbon atoms, particularly preferably a methylene group or -CH₂OCH₂-, which helps ensure stability during production or use.

A method of producing the PVA resin used in the present invention is not particularly limited, but examples of the production method preferably used include: (i) a method in which a copolymer of a vinyl ester monomer and a compound represented by the following general formula (2) is saponified; (ii) a method in which a copolymer of a vinyl ester monomer and a compound represented by the following general formula (3) is saponified and decarbonated; and (iii) a method in which a copolymer of a vinyl ester monomer and a compound represented by the following general formula (4) is saponified and deketalized.

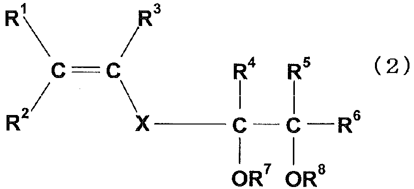

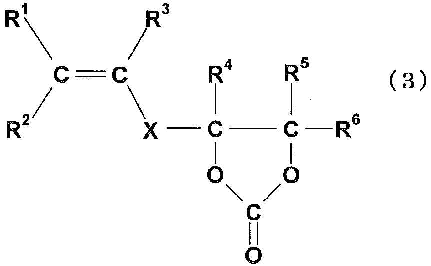

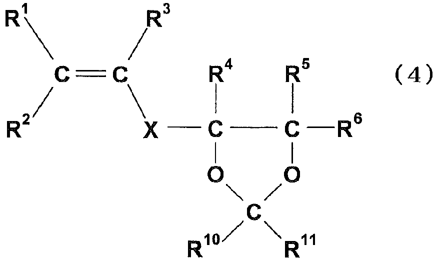

In the above general formulae (2), (3) and (4), R¹, R², R³, X, R⁴, R⁵ and R⁶ are the same as those in the general formula (1). R⁷ and R⁸ each independently represent a hydrogen atom or R⁹-CO- (wherein R⁹ is an alkyl group). R¹⁰ and R¹¹ each independently represent a hydrogen atom or an alkyl group.

Methods described in JP-A-2006-95825, for example, may be employed for the methods (i), (ii) and (iii).

For excellent copolymerization reactivity and industrial handling ease, preferably a 3,4-diacyloxy-1-butene, more preferably 3,4-diacetoxy-1-butene, is used as the compound represented by the general formula (2) in the method (i).

Where vinyl acetate is used as the vinyl ester monomer, and copolymerized with 3,4-diacetoxy-1-butene, the reactivity ratios of the respective monomers are r (vinyl acetate) = 0.710 and r(3,4-diacetoxy-1-butene) = 0.701. This indicates that 3,4-diacetoxy-1-butene is excellent in copolymerization reactivity with vinyl acetate, compared with vinyl ethylene carbonate used as the compound represented by the general formula (3) in the method (ii) wherein r(vinyl acetate) = 0.85 and r(vinyl ethylene carbonate) = 5.4.

The chain transfer constant of 3,4-diacetoxy-1-butene is Cx(3,4-diacetoxy-1-butene) = 0.003 (65°C). This indicates that 3,4-diacetoxy-1-butene is unlikely to make it difficult to increase the polymerization degree or to reduce the polymerization speed, compared with vinyl ethylene carbonate having a chain transfer constant of Cx (vinyl ethylene carbonate) = 0.005 (65°C) and 2,2-dimethyl-4-vinyl-1,3-dioxolane ,the compound represented by the general formula (4) in the method (iii), having a chain transfer constant of Cx(2,2-dimethyl-4-vinyl-1,3-dioxolane) = 0.023 (65°C).

A byproduct generated during the saponification of the copolymer of 3,4-diacetoxy-1-butene is the same as a byproduct compound generated during the saponification from a structural unit derived from vinyl acetate often used as a vinyl ester monomer. Therefore, it is possible to utilize conventional equipment without the need for additionally providing special devices or steps for post-treatment and solvent recovery. This is an industrially great advantage.

Incidentally, 3,4-diacetoxy-1-butene described above can be produced by synthesis through an epoxybutene derivative or by a reaction by which 1,4-diacetoxy-1-butene, an intermediate product obtained during production of 1,4-butanediol, is isomerized with a metal catalyst such as palladium chloride, as described, for example, in WO00/24702, USP5,623,086, USP6,072,079 or the like.

A reagent-grade product of 3,4-diacetoxy-1-butene is commercially available from Across Co., Ltd.

In a PVA resin prepared by the method (ii) or (iii), a carbonate ring or an acetal ring is liable to remain on its side chain if the decarbonation or the deacetalization is insufficient. Therefore, the PVA resin is liable to be crosslinked by the ring group to generate a gelatinous substance in a thermal drying step of a production process.

For this reason, the PVA resin prepared by the method (i) is preferably used in the present invention.

Examples of the vinyl ester monomer include vinyl formate, vinyl acetate, vinyl propionate, vinyl valerate, vinyl butyrate, vinyl isobutyrate, vinyl pivalate, vinyl caprate, vinyl laurate, vinyl stearate, vinyl benzoate and vinyl versatate, among which vinyl acetate is economically preferable.

Other comonomers may be copolymerized with the aforementioned monomers (the vinyl ester monomer and the compound represented by the general formula (2), (3) or (4)), as long as the properties of the resin are not significantly influenced. Examples of such comonomers include: α-olefins such as ethylene and propylene; hydroxyl-containing α-olefins such as 3-buten-1-ol, 4-penten-1-ol and 5-hexen-1,2-diol, and derivatives thereof such as acylation products thereof; unsaturated acids such as itaconic acid, maleic acid and acrylic acid, salts thereof, and monoalkyl and dialkyl esters thereof; nitriles such as acrylonitrile; amides such as methacrylamide and diacetone acrylamide; and olefin sulfonic acids such as ethylene sulfonic acid, allylsulfonic acid, methallylsulfonic acid and AMPS, and salts thereof.

The saponification degree of the PVA resin (A) used in the present invention is typically 60 to 100 mol%, particularly 70 to 99.9 mol%, further preferably 80 to 99.9 mol%, particularly preferably 90 to 99.9 mol%, further more preferably 98 to 99.8 mol% (as measured in conformity with JIS K6726). If the saponification degree is too low, the water solubility of the PVA resin is liable to deteriotrate, which makes it difficult to provide a homogeneous coating liquid.

The average polymerization degree of the PVA resin (A) is typically 100 to 4000, particularly 200 to 2000, preferably 300 to 1500 (as measured in conformity with JIS K6726).

If the average polymerization degree is too low, the resulting coating liquid is liable to have a lower viscosity, which makes it difficult to properly carry out the screen printing. Furthermore, the resulting film is liable to become thinner with an insufficient impurity. If the average polymerization degree is too high, on the other hand, the resulting coating liquid is not suitable for the screen printing, and therefore, is likely to cause a printing failure.

The proportion of the 1,2-diol structural unit contained in the PVA resin (A) is typically 0.5 to 30 mol%, particularly 1 to 20 mol%, preferably 3 to 15 mol%. If the proportion is too low, it is impossible to achieve the effect of the use of the PVA resin (A) containing the 1,2-diol structural unit. If the proportion is too high, the drying property is likely to deteriorate, thereby the productivity is reduced.

The proportion of the 1,2-diol structural unit in the PVA resin (A) can be determined based on ¹H-NMR spectrum of a fully saponified product of the PVA resin (with DMSO-d6 as a solvent and tetramethylsilane as an internal standard), more specifically, based on the peak areas attributable to hydroxyl protons, methine protons and methylene protons in the 1,2-diol unit, methylene protons in the main chain, and protons of hydroxyl groups connected to the main chain.

The PVA resin (A) used in the present invention may be a single type of PVA resin or a mixture of two or more types of PVA resins. In this case, a mixture of the PVA resin (A) and an unmodified PVA or a modified PVA resin other than the aforementioned PVA resin (A) may be used. Where the mixture is used, the averages of the polymerization degrees, the saponification degrees and the proportions of the 1,2-diol structural unit preferably fall within the aforementioned ranges.

The proportion of the PVA resin (A) in the coating liquid for impurity diffusion is typically 1 to 30 wt%, particularly 5 to 25 wt%, particularly preferably 10 to 20 wt%.

If the proportion of the PVA resin (A) is too small, the resulting coating liquid is liable to have a lower viscosity, which makes it difficult to stabilize the film forming. If the proportion of the PVA resin (A) is too great, on the other hand, the resulting coating liquid is liable to have a higher viscosity, which results in deteriorating coating efficiency and clogging a screen mesh in the screen printing.

### <Impurity (B)>

Next, the impurity (B) used in the present invention is described below.

Examples of the impurity (B) usable include a compound of a Group 13 element and a compound of a Group 15 element, which may be used either alone or in combination.

The Group 15 element compound is generally used as an impurity for production of an N-type semiconductor, and examples thereof include a phosphorus compound and an antimony compound. Particularly, the phosphorus compound is preferably used. Specific examples of the phosphorus compound include phosphoric acids such as phosphoric anhydride (P₂O₅) and phosphoric acid (H₃PO₄), salts of phosphoric acids such as melamine phosphate and ammonium phosphate, and esters of phosphoric acids such as acid phosphoxy methacrylate, 3-chloro-2-acid phosphoxyethyl methacrylate, acid phosphoxy polyethylene glycol monomethacrylate and acid phosphoxy polyoxypropylene glycol monomethacrylate and salts thereof, and phosphorus chloride, among which water-soluble phosphorus compounds are preferably used and the phosphoric acids are particularly preferably used.

These phosphorus compounds may be used either alone or in combination.

The proportion of the Group 15 element compound in the coating liquid for impurity diffusion is typically in a range of 0.1 to 30 wt%, particularly 0.1 to 10 wt%, particularly preferably 0.1 to 5 wt%.

The proportion of the Group 15 element compound based on 100 parts by weight of the PVA resin (A) is typically in a range of 1 to 300 parts by weight, particularly 3 to 200 parts by weight, particularly preferably 5 to 50 parts by weight.

If the proportion of the Group 15 element compound is too small, the content of the Group 15 element (phosphorus or the like) in the impurity diffusion layer is liable to be reduced, which makes it impossible to provide a sufficient resistance. If the proportion of the Group 15 element compound is too great, the solubility of the PVA resin (A) is liable to be insufficient.

In production of a P-type semiconductor, the Group 13 element compound is typically used as an impurity. Examples of the Group 13 element compound include a boron compound and an aluminum compound. Particularly, the boron compound is preferably used. Specific examples of the boron compound include boric acid, boric anhydride, boron trifluoride, boron trichloride, boron tribromide, boron triiodide, trimethyl borate, boron nitride, ammonium tetraborate (hydrate), alkyl borate ester, melamine borate and 9-BBN, among which water-soluble boron compounds are preferably used and boric acid and boric anhydride are particularly preferably used.

These boron compounds may be used either alone or in combination.

The proportion of the Group 13 element compound in the coating liquid for impurity diffusion is typically in a range of 0.1 to 30 wt%, particularly 0.1 to 10 wt%, particularly preferably 0.1 to 5 wt%.

The proportion of the Group 13 element compound per 100 parts by weight of the PVA resin (A) is typically in a range of 5 to 50 parts by weight, particularly 10 to 40 parts by weight.

If the proportion of the Group 13 element compound is too small, the content of the Group 13 element (boron or the like) in the impurity diffusion layer is liable to be reduced, which makes it impossible to provide a sufficient resistance. If the proportion of the Group 13 element compound is too great, the solubility of the PVA resin (A) is liable to be insufficient.

### <Water (C)>

The water (C) used for the coating liquid for impurity diffusion is preferably free from impurities such as alkali metals and heavy metals, and foreign matters to the utmost. Ultrapure water is most preferred, but deionized water or distilled water may be used.

The proportion of the water (C) in the coating liquid for impurity diffusion is typically in a range of 20 to 85 wt%, particularly 30 to 80 wt%, particularly preferably 40 to 75 wt%. If the proportion of the water (C) is too small, the viscosity of the resulting coating liquid is liable to be excessively increased, which results in deteriorating coating efficiency and the clogging a screen mesh in the screen printing. If the proportion of the water (C) is too great, the viscosity of the resulting coating liquid is liable to be excessively reduced, which makes it difficult to stabilize the film forming, or causes the impurity content of the impurity diffusion layer to become excessively small.

### <Alcohol (D)>

An alcohol (D) is preferably further blended in the coating liquid for impurity diffusion. By blending the alcohol, the storage stability and the fluid stability of the coating liquid and the leveling property of the film can be improved.

Specific examples of the alcohol (D) include:
monovalent alcohols such as methanol (65°C), ethanol (78°C) and isopropanol (82°C); divalent alcohols such as ethylene glycol (197°C), diethylene glycol (244°C), triethylene glycol (287°C), tetraethylene glycol (314°C) and propylene glycol (188°C); trivalent to polyvalent alcohols such as glycerin (290°C), trimethylol propane (292°C), sorbitol (296°C) and mannitol (290°C to 295°C), pentaerythritol (276°C) and polyglycerin; and alcohol derivatives such as ethylene glycol monomethyl ether (124°C), ethylene glycol monoethyl ether (136°C), ethylene glycol mono-n-butyl ether (171°C), propylene glycol monomethyl ether (120°C) and diethylene glycol monomethyl ether (methyl carbitol) (194°C). Parenthesized numerals each indicate a boiling point.

These may be used either alone or in combination.

Particularly, it is preferred to use an alcohol having a boiling point higher than water, i.e., having a boiling point of 100°C or higher, more preferably 150°C to 350°C, particularly preferably 200°C to 300°C, because such an alcohol suppresses rapid drying of the film after printing and has more excellent effect on improving a leveling property.

The proportion of the alcohol (D) blended in the coating liquid for impurity diffusion is typically in a range of 5 to 70 parts by weight, particularly 10 to 60 parts by weight, particularly preferably 30 to 50 parts by weight, based on the overall amount of the coating liquid.

The proportion of the alcohol (D) per 100 parts by weight of the water (C) is typically in a range of 5 to 200 parts by weight, particularly 20 to 150 parts by weight, further preferably 80 to 120 parts by weight. If the proportion of the alcohol (D) is too small, it is impossible to sufficiently achieve the effect on improving the fluidity and the leveling effect. If the proportion of the alcohol (D) is too great, on the other hand, the solubility of the PVA resin (A) deteriorates, which makes it impossible to provide a homogeneous coating liquid. Where an alcohol with a higher-boiling point is used, an excessively great proportion of the alcohol (D) is not preferred because the coating liquid is required to be dried at a higher temperature for a longer period of time.

### <Surfactant (E)>

In a preferred embodiment, a surfactant (E) is further blended in the coating liquid for impurity diffusion. The blending of the surfactant improves the wettability of the coating liquid on a semiconductor surface, and suppresses the foaming of the coating liquid, thereby preventing a printing failure attributable to the foaming.

Surfactants used for aqueous solutions are broadly classified into nonionic surfactants, cationic surfactants and anionic surfactants. Any of these surfactants may be used, but the nonionic surfactants are preferred because a metal component is less liable to be incorporated into the semiconductor.

Known nonionic surfactants may be used. Specific examples of the nonionic surfactants include hydrocarbon surfactants such as ethylene oxide-propylene oxide block copolymers and acetylene glycol derivatives, silicone surfactants and fluorine-containing surfactants.

The hydrocarbon surfactants, particularly acetylene glycol derivatives, are preferably used because the hydrocarbon surfactants prevent the inventive coating liquid from foaming and are excellent in defoaming property.

An acetylene glycol derivative represented by the following formula (5) is preferably used: 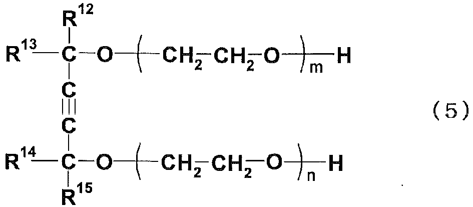 wherein R¹² and R¹⁵ each independently represent a C₁ to C₂₀ alkyl group, particularly a C₁ to C₅ alkyl group, particularly preferably a C₃ to C₅ alkyl group; R¹³ and R¹⁴ each independently represent a C₁ to C₃ alkyl group, particularly preferably a methyl group; and R¹² and R¹⁵, and R¹³ and R¹⁴, which may be the same or different, preferably have the same structure.

Further, n and m each represent an integer of 0 to 30, and particularly m + n is 1 to 10, particularly 1 to 5, and particularly preferably 1 to 3.

Specific examples of the acetylene glycol derivative include an ethylene oxide adduct of 2,5,8,11-tetramethyl-6-dodecyn-5,8-diol, an ethylene oxide adduct of 5,8-dimethyl-6-dodecyn-5,8-diol, an ethylene oxide adduct of 2,4,7,9-tetramethyl-5-decyn-4,7-diol, an ethylene oxide adduct of 4,7-dimethyl-5-decyn-4,7-diol, an ethylene oxide adduct of 2,3,6,7-tetramethyl-4-octyn-3,6-diol, an ethylene oxide adduct of 3,6-dimethyl-4-octyn-3,6-diol and an ethylene oxide adduct of 2,5-dimethyl-3-hexyn-2,5-diol.

Among these, the ethylene oxide adduct of 2,4,7,9-tetramethyl-5-decyn-4,7-diol is preferably used, in which the number (m + n) of added ethylene oxide units is preferably 1 to 2.

Commercially available examples of surfactants as the acetylene glycol derivative include SURFINOL series products available from Nissin Chemical Co., Ltd.

The proportion of the surfactant (E) to be blended in the coating liquid for impurity diffusion is typically in a range of 0.1 to 10 wt%, particularly 0.3 to 8 wt%, particularly preferably 0.5 to 5 wt%, in the coating liquid. If the proportion of the surfactant (E) is too small, the foaming suppressing effect and the defoaming effect are liable to be insufficient. If the proportion of the surfactant (E) is too great, on the other hand, the surfactant is liable to be separated from the liquid, which makes it impossible to provide a homogeneous solution.

### <Other Additives>

Various types of inorganic particles may be blended in the coating liquid for impurity diffusion in order to improve the screen printing properties.

Examples of the inorganic particles include silica materials such as colloidal silica, amorphous silica, fumed silica, among which the colloidal silica is preferably used.

The proportion of the inorganic particles in the coating liquid is typically in a range of 0.5 to 20 wt%, particularly preferably 1 to 10 wt%.

### <Coating Liquid for Impurity Diffusion>

The inventive coating liquid for impurity diffusion contains the PVA resin (A), the impurity (B) and the water (C) described above, and as required, the alcohol (D), the surfactant (E) and the other additives.

The viscosity of the coating liquid for impurity diffusion at 20°C is typically in a range of 300 to 100,000 mPa·s, particularly 500 to 10,000 mPa·s, particularly preferably 700 to 6,000 mPa·s. The viscosity is measured by means of a B-type viscometer.

If the concentration and the viscosity of the coating liquid are too low, it is difficult to stabilize the film forming. Furthermore, the content of phosphorus, boron or the like in the resulting impurity diffusion layer is liable to be insufficient. If the viscosity of the coating liquid is too high, on the other hand, the coating efficiency is liable to be deteriorated. Furthermore, the screen mesh is liable to be clogged in the screen printing.

The coating liquid for impurity diffusion is prepared by dissolving the PVA resin (A) and the impurity (B) described above in the water (C), and as required, blending the alcohol (D), the surfactant (E) and the inorganic particles (F) in the resulting solution. The methods for preparing the coating liquid include, but not limited to, a method comprising the steps of preparing the PVA resin (A) in the form of an aqueous solution and then blending the impurity (B) and the other additives with the aqueous solution, and a method comprising the steps of preliminarily mixing the PVA resin (A) and the impurity (B) together, adding the water (C) to the resulting mixture, dissolving the mixture in the water (C) with stirring and heating, and then adding the other additives to the resulting solution.

The inventive coating liquid for impurity diffusion thus prepared is excellent in storage stability and, therefore, can be prepared and stored in bulk or divided into smaller quantities for delivery, or can be partly used with the rest thereof stored.

### <Semiconductor>

Next, a semiconductor produced by using the coating liquid for impurity diffusion is described as below.

The semiconductor is produced by means of forming an impurity diffusion layer of phosphorus, boron and such therein, with a method comprising the steps of applying the coating liquid for impurity diffusion onto a semiconductor substrate of such as silicon or germanium, drying, burning and diffusing the coating liquid.

A known method is used for applying the coating liquid for impurity diffusion onto the semiconductor substrate. Specific examples of the method include a screen printing method, a gravure printing method, a relief printing method, a lithographic printing method, a spin coater method, a comma coater method, a die head coater method, and a die lip coater method. Particularly, the inventive coating liquid is most effective for use in the screen printing method, and is capable of forming a homogeneous film on a large-scale wafer having a size of 4 inches or greater.

The amount of the coating liquid applied onto the semiconductor substrate varies depending on the type of the substrate, the use purpose of the semiconductor, the amount of the impurity (a phosphorus compound, a boron compound or the like) contained in the coating liquid, a desired phosphorus or boron content, and the like, but typically in a range of 1 to 100 g/m², particularly 1 to 50 g/m².

In the subsequent drying step, a volatile component such as water is removed from the resulting film. The drying conditions are properly set, but the temperature is typically 20°C to 300°C, particularly 100°C to 200°C, and the drying period is typically 1 to 60 minutes, particularly 5 to 30 minutes. The drying method is not particularly limited, but various known methods such as a hot air drying method, an infrared heating drying method, and a vacuum drying method may be employed.

As required, the applying step and the drying step may be sequentially performed.

In the subsequent burning step (degreasing step), most of the organic component in the coating film is removed with the use of an electric oven or the like. The burning conditions should be properly controlled according to the formulation of the coating liquid and the thickness of the coating film. This step is typically performed at 300°C to 1000°C, particularly 400°C to 800°C for a period of 1 to 120 minutes, particularly 5 to 60 minutes.

In the diffusion step, phosphorus, boron or the like is diffused into the semiconductor substrate to form an impurity diffusion layer. A single semiconductor substrate or a bunch of semiconductor substrates stacked one on another is treated at 800°C to 1400°C with the use of an electric oven or the like as in the burning step.

The burning step and the diffusion step may be performed as a single step. If the diffusion proceeds and a desired resistance is achieved in the burning step, the diffusion step may be obviated.

The surface resistance of the semiconductor can be controlled by the impurity content, the diffusion temperature, the diffusion period and the like. The surface resistance is typically controlled at a level suitable for the use purpose in a range of 0.03 to 10000 Ω/□.

### EXAMPLES

Examples of the present invention are described hereinafter. The present invention and its scope are not limited to the following examples.

In the examples, "parts" and "%" represent weight unless otherwise specified.

### Example of the Production Process 1

### <Production of PVA Resin (A1)>

A reaction vessel equipped with a reflux condenser, a dropping funnel and a stirrer, was charged with 1500 parts of vinyl acetate, 800 parts of methanol and 240 parts of 3,4-diacetoxy-1-butene, and then 0.05 mol% of azobisisobutyronitrile (per the amount of the vinyl acetate) was added. The resulting mixture was heated in nitrogen stream with stirring, whereby polymerization was started. When the polymerization rate of vinyl acetate reached 87%, m-dinitrobenzene was added to the resulting mixture to end the polymerization. Subsequently, unreacted vinyl acetate monomers were expelled outside the system by blowing methanol vapor into the system, whereby a methanol solution of a copolymer was prepared.

In turn, the methanol solution was further diluted to a concentration of 40% with methanol, and the resulting methanol solution was places into a kneader. While the temperature of the solution was kept at 40°C, a 2% methanol solution of sodium hydroxide was added to the methanol solution of the copolymer in a proportion of 8 mmol per 1 mol of the total of the vinyl acetate structural unit and the 3,4-diacetoxy-1-butene structural unit in the copolymer to initiate saponification. During the saponification, a saponification product was precipitated into particles. The particles were filtered out, thoroughly washed with methanol, and dried in a hot air drier. Thus, an intended PVA resin (A1) was produced.

The saponification degree of the PVA resin (A1) thus produced was 99.8 mol% as determined by an analysis of an alkali consumption required for the hydrolysis of the remaining vinyl acetate and 3,4-diacetoxy-1-butene. The average polymerization degree was 350 as determined by an analysis performed in conformity with JIS K6726. The proportion of the 1,2-diol structural unit represented by the general formula (1) was 8 mol% (see Table 1) as determined based on an integration value obtained through measurement of ¹H-NMR (300 MHz proton NMR using a DMSO-d6 solution and using tetramethylsilane as an internal standard at 50°C).

### Example of the Production Process 2

### <Production of PVA Resin (A2)>

A reaction vessel equipped with a reflux condenser, a dropping funnel and a stirrer, was charged with 1500 parts of vinyl acetate, 2100 parts of methanol and 180 parts of 3,4-diacetoxy-1-butene, and then 0.06 mol% of azobisisobutyronitrile (per the amount of the vinyl acetate) was added. The resulting mixture was heated in nitrogen stream with stirring, whereby polymerization was started. When the polymerization rate of vinyl acetate reached 80%, m-dinitrobenzene was added to the resulting mixture to end the polymerization. Subsequently, unreacted vinyl acetate monomers were expelled outside the system by blowing methanol vapor into the system, whereby a methanol solution of a copolymer was prepared.

In turn, the methanol solution was further diluted to a concentration of 35% with methanol, and the resulting methanol solution was placed into a kneader. While the temperature of the solution was kept at 35°C, a 2% methanol solution of sodium hydroxide was added to the methanol solution of the copolymer in a proportion of 8 mmol per 1 mol of the total of the vinyl acetate structural unit and the 3,4-diacetoxy-1-butene structural unit in the copolymer to initiate saponification. During the saponification, a saponification product was precipitated into particles. The particles were filtered out, thoroughly washed with methanol, and dried in a hot air drier. Thus, an intended PVA resin (A2) was produced.

The saponification degree of the PVA resin (A2) thus produced was 99.6 mol% as determined by an analysis of an alkali consumption required for the hydrolysis of the remaining vinyl acetate and 3,4-diacetoxy-1-butene. The average polymerization degree was 470 as determined by an analysis performed in conformity with JIS K6726. The proportion of the 1,2-diol structural unit represented by the general formula (1) was 12 mol% (see Table 1) as determined based on an integration value obtained through measurement of ¹H-NMR (300 MHz proton NMR using a DMSO-d6 solution and using tetramethylsilane as an internal standard at 50°C).

### Example of the Production Process 3

### <Production of PVA Resin (A3)>

A reaction vessel equipped with a reflux condenser, a dropping funnel and a stirrer, was charged with 1000 parts of vinyl acetate, 400 parts of methanol and 120 parts of 3,4-diacetoxy-1-butene, and then 0.06 mol% of azobisisobutyronitrile (per the amount of the vinyl acetate) was added. The resulting mixture was heated in nitrogen stream with stirring, whereby polymerization was started. When the polymerization rate of vinyl acetate reached 80%, m-dinitrobenzene was added to the resulting mixture to end the polymerization. Subsequently, unreacted vinyl acetate monomers were expelled outside the system by blowing methanol vapor into the system, whereby a methanol solution of a copolymer was prepared.

In turn, the methanol solution was further diluted to a concentration of 30% with methanol, and the resulting methanol solution was placed into a kneader. While the temperature of the solution was kept at 35°C, a 2% methanol solution of sodium hydroxide was added to the methanol solution of the copolymer in a proportion of 8 mmol per 1 mol of the total of the vinyl acetate structural unit and the 3,4-diacetoxy-1-butene structural unit in the copolymer to initiate saponification. During the saponification, a saponification product was precipitated into particles. The particles were filtered out, thoroughly washed with methanol, and dried in a hot air drier. Thus, an intended PVA resin (A3) was produced.

The saponification degree of the PVA resin (A3) thus produced was 99.7 mol% as determined by an analysis of an alkali consumption required for the hydrolysis of the remaining vinyl acetate and 3,4-diacetoxy-1-butene. The average polymerization degree was 1200 as determined by an analysis performed in conformity with JIS K6726. The proportion of the 1,2-diol structural unit represented by the general formula (1) was 6 mol% (see Table 1) as determined based on an integration value obtained through measurement of ¹H-NMR (300 MHz proton NMR using a DMSO-d6 solution and using tetramethylsilane as an internal standard at 50°C).

### Example 1

### <Preparation of Phosphorus Diffusion Coating Liquid>

First, 17g of the PVA resin (A1) produced in Example of the Production Process 1 was added to and dissolved in 40.5g of ultrapure water (C) by heating and stirring, whereby a PVA resin solution was prepared.

Further, 1.5g of an ethylene oxide adduct of 2,4,7,9-tetramethyl-5-decyn-4,7-diol, an acetylene glycol derivative (in the general formula (1), m + n ≈ 1.3), was added as the surfactant (E) to 40 g of glycerin used as the alcohol (D), whereby a surfactant solution was prepared.

Then, 1.2g (a pure content of 1g) of a phosphoric acid aqueous solution (containing 85 wt% of phosphoric acid and 15 wt% of water for EL and available from Kanto Chemical Industry Co., Ltd.) as the phosphorus compound (B) and the surfactant solution were added to the PVA resin solution in order, and the resulting mixture was stirred, whereby a phosphorus diffusion coating liquid was prepared. The viscosity of the coating liquid thus prepared was shown in Table 2.

### <Application on Semiconductor Substrate>

Screen printing was carried out on a semiconductor substrate (of polycrystalline silicon having a size of 156mm square and a thickness of 200µm) under the following printing conditions. The coating liquid was applied onto a printing plate with a scraper, and after lapse of predetermined periods (5, 15 and 30 minutes) in this state, the printing was carried out again. The resulting printed surface was visually observed, and printing properties were evaluated based on the following evaluation criteria. The results are shown in Table 3.

### (Printing Conditions)

Printer: LS-34GX available from Newlong Seimitu Kogyo CO., Ltd
   Squeegee: NM squeegee (hardness of 60) available from Newlong Seimitu Kogyo CO., Ltd Squeegee angle: 80 degrees
   Scraper: NM squeegee (hardness of 60) available from Newlong Seimitu Kogyo CO., Ltd Scraper angle: 86 degrees
   Printing pressure: 0.2 MPa
Screen printing plate: available from Tokyo Process Service Co., Ltd.
   Printing plate size: 450 mm square
   Mesh type: V330
   Emulsion type: TN-1
   Emulsion thickness: 10 µm
   Pattern: L/S = 80 to 220 µm, 20 µm / L×3 and two 30-mm square solid patterns
Printing environment: 23°C, 60 %RH

### (Evaluation Criteria)

○: All the patterns were printed.
×: Pattern chipping was observed.

### <Diffusion>

After the semiconductor substrate, on which the phosphorus diffusion coating liquid was screen-printed as described above, was dried at 150°C for two minutes in a hot air circulation drier, the semiconductor substrate was put in a muffle furnace at 900°C, maintained for 15 minutes, and taken out. Then, the substrate was shaken and cleaned in a 46% hydrogen fluoride aqueous solution. Thus, a semiconductor including a phosphorus diffusion layer formed in the semiconductor substrate was produced.

The surface resistance of the center of the resulting semiconductor with a 30-mm square pattern was measured by means of a resistance meter (LORESTAR with a PSP probe available from Mitsubishi Analytech Co., Ltd.) The results are shown in Table 3.

### Example 2

A coating liquid for phosphorus diffusion was prepared in substantially the same manner as in Example 1, except that the PVA resin (A2) produced in Example of the Production Process 2 was used as the PVA resin (A) and the respective components were blended in proportions as shown in Table 2. The coating liquid for phosphorus diffusion was evaluated in the same manner as in Example 1. The viscosity of the coating liquid is shown in Table 2, and the evaluation results are shown in Table 3.

A semiconductor was produced in substantially the same manner as Example 1 with the coating liquid, and evaluated in the same manner. The results are shown in Table 3.

### Comparative Examples 1 and 2

Coating liquids for phosphorus diffusion were prepared in substantially the same manner as in Example 1, except that an unmodified PVA (a1) (having a polymerization degree of 320 and a saponification degree of 98.3 mol%) and an unmodified PVA (a2) (having a polymerization degree of 450 and a saponification degree of 87.5 mol%) were respectively used as the PVA resin and the respective components were blended in proportions as shown in Table 2. The coating liquids for phosphorus diffusion were evaluated in the same manner as in Example 1. The viscosities of the coating liquids are shown in Table 2, and the evaluation results are shown in Table 3.

Semiconductors were produced with the coating liquids and evaluated in substantially the same manner as in Example 1. The results are shown in Table 3.

### Example 3

A coating liquid for phosphorus diffusion was prepared in substantially the same manner as in Example 1, except that the PVA resin (A3) produced in Example of the Production Process 3, diphosphorus pentaoxide and methyl carbitol were used as the PVA resin (A), the phosphorus compound (B) and the alcohol (D), respectively, and the surfactant (E) was not blended, and that the respective components were blended in proportions as shown in Table 2. The coating liquid for phosphorus diffusion was evaluated in the same manner as in Example 1. The viscosity of the coating liquid is shown in Table 2, and the evaluation results are shown in Table 3.

A semiconductor was produced with this coating liquid and evaluated in the same manner as in Example 1. The results are shown in Table 3.

### Example 4

A coating liquid for phosphorus diffusion was prepared in substantially the same manner as in Example 1, except that the PVA resin (A3) produced in Example of the Production Process 3 was used as the PVA resin (A), and the alcohol (D) and the surfactant (E) were not blended, and that the respective components were blended in proportions as shown in Table 2. The coating liquid for phosphorus diffusion was evaluated in the same manner as in Example 1. The viscosity of the coating liquid is shown in Table 2, and the evaluation results are shown in Table 3.

A semiconductor was produced with this coating liquid and evaluated in the same manner as in Example1. The results are shown in Table 3.

**Table 1**

| | Proportion (mol%) of 1,2-diol structural unit | Polymerization degree | Saponification degree (mol%) |
|---|---|---|---|
| PVA resin (A1) | 8 | 350 | 99.8 |
| PVA resin (A2) | 12 | 470 | 99.6 |
| PVA resin (A3) | 6 | 1200 | 99.7 |
| Unmodified PVA (a1) | - | 320 | 98.3 |
| Unmodified PVA (a2) | - | 450 | 87.5 |

**Table 2**

| (g) | | | | | | | |
|---|---|---|---|---|---|---|---|
| | | Example 1 | Example 2 | Comparative Example 1 | Comparative Example 2 | Example 3 | Example 4 |
| PVA resin | | | | | | | |
| | PVA resin (A1) | 17 | - | - | - | - | - |
| | PVA resin (A2) | - | 23 | - | - | - | - |
| | PVA resin (A3) | - | - | - | - | 17 | 10 |
| | Unmodified PVA resin (a1) | - | - | 17 | - | - | - |
| | Unmodified PVA resin (a2) | - | - | - | 17 | - | - |

| Phosphorus compound (B) | | | | | | | |
|---|---|---|---|---|---|---|---|
| | Phosphoric acid | 1 | 1 | 1 | 1 | - | 25 |
| | Diphosphorus pentaoxide | - | - | - | - | 7 | - |
| | Water (C) | 40.5 | 34.5 | 40.5 | 40.5 | 66 | 65 |

| Alcohol (D) | | | | | | | |
|---|---|---|---|---|---|---|---|
| | Glycerin | 40 | 40 | 40 | 40 | - | - |
| | Methyl carbitol | - | - | - | - | 10 | - |
| | Surfactant (E) | 1.5 | 1.5 | 1.5 | 1.5 | - | - |
| | Viscosity (mPa·s) | 870 | 5500 | 2560 | 7000 | 3920 | 700 |

**Table 3**

| | | Example 1 | Example 2 | Comparative Example 1 | Comparative Example 2 | Example 3 | Example 4 |
|---|---|---|---|---|---|---|---|
| Printing property | | | | | | | |
| | Initially | ○ | ○ | ○ | ○ | ○ | ○ |
| | After 5 minutes | ○ | ○ | × | × | ○ | ○ |
| | After 15 minutes | ○ | ○ | - | - | × | × |
| | After 30 minutes | ○ | ○ | - | - | - | - |
| Surface resistance (**Ω**/□) | | 60 | 60 | 50 | 35 | 50 | 30 |

In screen printing, the coating liquid for phosphorus diffusion showed excellent printing properties even after the lapse of the predetermined periods. In the comparative examples using the unmodified PVAs, on the other hand, the printing properties were initially excellent; however, when the printing was carried out after the lapse of the periods, pattern chipping occurred.

The semiconductors produced with the coating liquid for inventive phosphorus diffusion each had a higher surface resistance.

### Example 5

### <Preparation of Coating Liquid for Boron Diffusion>

First, 18g of the PVA resin (A1) produced in Example of the Production Process 1 was added to and dissolved in 44g of ultrapure water (C) by heating with stirring, whereby a PVA resin solution was prepared.

Further, 1.8g of an ethylene oxide adduct of 2,4,7,9-tetramethyl-5-decyn-4,7-diol, an acetylene glycol derivative (in the general formula (1), m + n ≈ 1.3), was added as the surfactant (E) to 34g of glycerin used as the alcohol (D), whereby a surfactant solution was prepared.

Then, 2.2g of boric acid as the boron compound (B) and the surfactant solution were added to the PVA resin solution in order, and the resulting mixture was stirred, whereby a coating liquid for boron diffusion was prepared. The formulation and the viscosity of the coating liquid thus prepared are shown in Table 4.

### <Application on Semiconductor Substrate>

Screen printing was carried out on a semiconductor substrate (of polycrystalline silicon having a size of 156 mm square and a thickness of 200 µm) under the following printing conditions. The coating liquid was applied onto a printing plate with a scraper, and after lapse of predetermined periods (5 and 15 minutes) in this state, the printing was carried out again. The resulting printed surface was visually observed, and the printing properties were evaluated based on the following evaluation criteria. The results are shown in Table 5.

### (Printing Conditions)

Printer: LS-34GX available from Newlong Seimitu Kogyo CO., Ltd
   Squeegee: NM squeegee (hardness of 60) available from Newlong Seimitu Kogyo CO., Ltd Squeegee angle: 80 degrees
   Scraper: NM squeegee (hardness of 60) available from Newlong Seimitu Kogyo CO., Ltd
   Scraper angle: 86 degrees
   Printing pressure: 0.2 MPa
Screen printing plate: available from Tokyo Process Service Co., Ltd.
   Printing plate size: 450 mm square
   Mesh type: V330
   Emulsion type: TN-1
   Emulsion thickness: 10 µm
   Pattern: L/S = 80 to 220 µm, 20 µm / L×3 and two 30-mm square solid patterns
Printing environment: 23°C, 60 %RH

### (Evaluation Criteria)

○: All the patterns were printed.
×: Pattern chipping was observed.

### <Diffusion>

After the semiconductor substrate, on which the inventive coating liquid for boron diffusion was screen-printed, was dried at 150°C for 2 minutes in a hot air circulation drier, the semiconductor substrate was put in a muffle furnace at 950°C, maintained for 15 minutes, and taken out. Then, the substrate was shaken and cleaned in a 46% hydrogen fluoride aqueous solution. Thus, a semiconductor including a boron diffusion layer formed in the semiconductor substrate was produced.

The surface resistance of the center of the resulting semiconductor with 30-mm square pattern was measured by means of a resistance meter (LORESTAR with a PSP probe available from Mitsubishi Analytech Co., Ltd.) The results are shown in Table 5.

### Example 6

A coating liquid for boron diffusion was prepared in substantially the same manner as in Example 5, except that 54g of ultrapure water (C), 7g of the PVA resin (A3) produced in Example of the Production Process 3 as the PVA resin (A) and 35g of methyl carbitol as the alcohol (D) were used. The coating liquid for boron diffusion was evaluated in the same manner as in Example 5. The formulation and the viscosity of the coating liquid are shown in Table 4, and the evaluation results are shown in Table 5.

A semiconductor was produced with this coating liquid and evaluated in the same manner as in Example 1. The results are shown in Table 5.

### Comparative Example 3

An attempt was made to prepare a coating liquid for boron diffusion in substantially the same manner as in Example 5, except that 47g of ultrapure water (C) and 15g of an unmodified PVA (a1) (having a polymerization degree of 320 and a saponification degree of 98.3 mol%) as the PVA resin were used. However, the resulting mixture was gelatinized during the preparation.

### Comparative Example 4

A coating liquid for boron diffusion was prepared in substantially the same manner as in Example 5, except that 47.4g of ultrapure water (C), 13. 6g of an unmodified PVA (a2) (having a polymerization degree of 450 and a saponification degree of 87.5 mol%) as the PVA resin and 35g of methyl carbitol as the alcohol (D) were used. The coating liquid for boron diffusion was evaluated in the same manner as in Example 5. The formulation and the viscosity of the coating liquid are shown in Table 4, and the evaluation results are shown in Table 5.

A semiconductor was produced with this coating liquid and evaluated in the same manner as in Example 1. The results are shown in Table 5.

**Table 4**

| (g) | | | | | |
|---|---|---|---|---|---|
| | | Example 5 | Example 6 | Comparative Example 3 | Comparative Example 4 |
| PVA resin | | | | | |
| | PVA resin (A1) | 18 | - | - | - |
| | PVA resin (A3) | - | 7 | - | - |
| | Unmodified PVA (a1) | - | - | 15 | - |
| | Unmodified PVA (a2) | - | - | - | 13.6 |
| Boric acid (B) | | 2.2 | 2.2 | 2.2 | 2.2 |
| Water (C) | | 44 | 54 | 47 | 47.4 |

| Alcohol (D) | | | | | |
|---|---|---|---|---|---|
| | Glycerin | 34 | - | 34 | - |
| | Methyl carbitol | - | 35 | - | 35 |
| | Surfactant (E) | 1.8 | 1.8 | 1.8 | 1.8 |
| | Viscosity (mPa·s) | 1300 | 1200 | Gelatinized | 2900 |

**Table 5**

| | | Example 5 | Example 6 | Comparative Example 3 | Comparative Example 4 |
|---|---|---|---|---|---|
| Printing property | | | | | |
| | Initially | ○ | ○ | - | ○ |
| | After 5 minutes | ○ | ○ | - | × |
| | After 15 minutes | ○ | × | - | - |
| Surface resistance (**Ω**/□) | | 50 | 60 | - | 50 |

In the examples in which the inventive coating liquids for boron diffusion were used, the printing properties were excellent during the screen printing even after the lapse of the predetermined periods. In the comparative examples in which the unmodified PVAs were used, in contrast, the coating liquid containing the PVA having a higher saponification degree was gelatinized, and the coating liquid containing the partially saponified PVA was properly prepared but suffered from pattern chipping when the printing was carried out after a lapse of 5 minutes.

The semiconductors produced with the inventive coating liquid for boron diffusion each had a higher surface resistance.

While the present invention is described above by way of specific examples, these examples are merely illustrative but not limitative. Various alterations made within the equivalent scope of the appended claims are all deemed to fall within the scope of the present invention.

The inventive coating liquid for impurity diffusion is highly stable and permits long-term continuous printing in a screen printing process, and therefore, is useful for production of semiconductors. Particularly, the coating liquid for impurity diffusion ensures excellent printing accuracy for a longer period of time in a pattern printing process for production of solar cells and the like, and therefore, is industrially very useful.

## Claims

1. A coating liquid for impurity diffusion which comprises:
(A) a polyvinyl alcohol resin having a 1,2-diol structural unit represented by the following general formula (1): 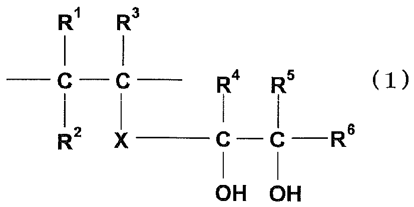 wherein R¹, R² and R³ each independently represent a hydrogen atom or an organic group, X represents a single bond or a bond chain, and R⁴, R⁵ and R⁶ each independently represent a hydrogen atom or an organic group;
(B) an impurity; and
(C) water.

2. The coating liquid for impurity diffusion according to claim 1, wherein the impurity (B) comprises at least one of a compound of a Group 13 element and a compound of a Group 15 element.

3. The coating liquid for impurity diffusion according to claim 1 or 2, comprising: (D) an alcohol.

4. The coating liquid for impurity diffusion according to any one of claims 1 to 3, comprising:
(E) a surfactant.
